(19) **Europäisches Patentamt European Patent Office Office européen des brevets**

(11) **EP 1 225 593 B1**

(12) **FASCICULE DE BREVET EUROPEEN**

(45) Date de publication et mention
de la délivrance du brevet:
**16.04.2008 Bulletin 2008/16**

(51) Int Cl.:
**G11C 11/16** *(2006.01)* **H01F 10/32** *(2006.01)*

(21) Numéro de dépôt: **01403131.4**

(22) Date de dépôt: **05.12.2001**

(54) **Dispositif magnétique à polarisation de spin et à rotation d'aimantation, mémoire et procédé d'écriture utilisant ce dispositif**

Magnetische Anordnung basiert auf Spinpolarisierung und Rotationsmagnetisierung, Speicher und Schreibverfahren unter Verwendung einer solcher

Magnetic device based on spin polarization and rotating magnetization, memory and writing procedure utlilizing said device

(84) Etats contractants désignés:
**DE GB IT**

(30) Priorité: **07.12.2000 FR 0015893**

(43) Date de publication de la demande:
**24.07.2002 Bulletin 2002/30**

(73) Titulaire: **COMMISSARIAT A L'ENERGIE ATOMIQUE**
**75015 Paris (FR)**

(72) Inventeurs:
• **Redon, Olivier**
**Le Grand Pré,**
**38170 Seyssinet (FR)**

• **Dieny, Bernard**
**38250 Lans-en-Vercors (FR)**
• **Rodmacq, Bernard**
**38113 Veurey-Voroize (FR)**

(74) Mandataire: **Poulin, Gérard et al**
**Société BREVATOME**
**3, rue du Docteur Lancereaux**
**75008 Paris (FR)**

(56) Documents cités:
**US-A- 5 856 897**

## Description

### Domaine technique

La présente invention a pour objet un dispositif magnétique à polarisation de spin et à rotation d'aimantation ainsi qu'une mémoire utilisant ce dispositif et un procédé d'écriture.

Elle trouve une application en électronique et notamment dans la réalisation de points mémoire et de mémoire de type MRAM ("Magnetic Random Access Memory" ou mémoire magnétique à accès direct (ou aléatoire)).

### Etat de la technique antérieure

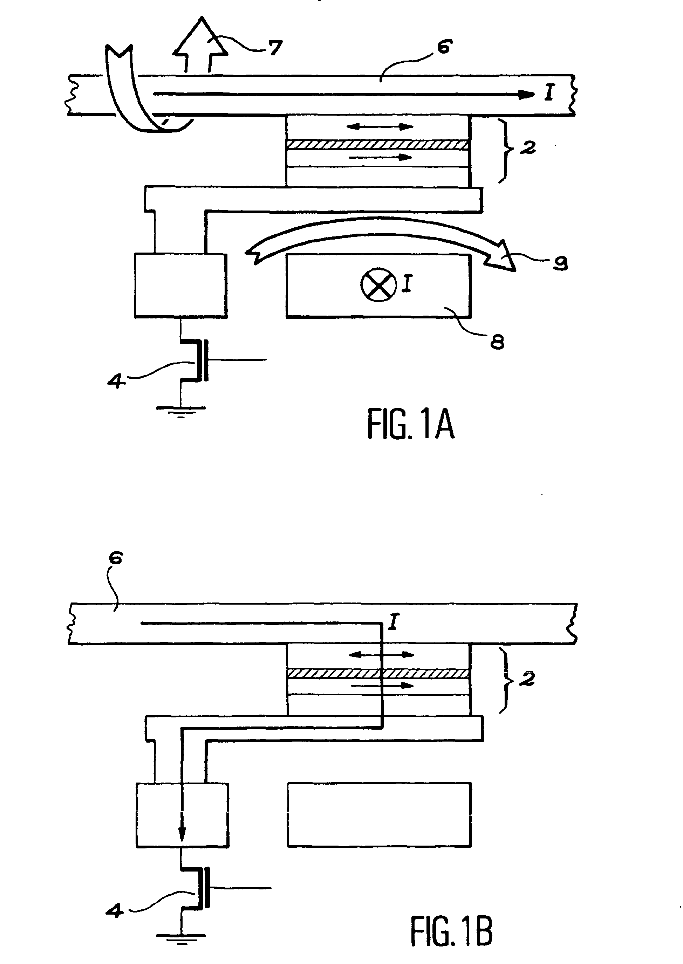

Les mémoires magnétiques MRAM ont connu un regain d'intérêt avec la mise au point de jonctions tunnel magnétiques (en abrégé MTJ pour "Magnetic Tunnel Junction") présentant une forte magnétorésistance à température ambiante. Les figures 1A et 1B annexées illustrent schématiquement la structure et la fonction d'une telle jonction.

La jonction porte la référence 2. Il s'agit d'un empilement comprenant une couche d'oxyde en sandwich entre deux couches magnétiques. Ce système fonctionne comme une vanne de spin, à la différence que le courant circule perpendiculairement aux plans des couches. L'une des couches magnétiques est dite "libre" car son aimantation peut s'orienter dans un champ magnétique extérieur (flèche bidirectionnelle) ; l'autre est dite "piégée" car sa direction d'aimantation est fixée par une couche d'échange antiferromagnétique (flèche unidirectionnelle). Lorsque les aimantations des couches magnétiques sont antiparallèles, la résistance de la jonction est élevée ; lorsque les aimantations sont parallèles, la résistance devient faible. La variation relative de résistance entre ces deux états peut atteindre 40% par un choix approprié des matériaux.

La jonction 2 est placée entre un transistor de commutation 4 et une ligne d'amenée de courant 6. Un courant passant dans celle-ci produit un champ magnétique 7. Un conducteur 8, orthogonal à la ligne d'amenée de courant 6 (c'est-à-dire en l'espèce, perpendiculaire au plan de la figure) permet de produire un second champ magnétique 9 (situé dans le plan de la figure).

Dans le mode "écriture" (Fig. 1A), le transistor 4 est bloqué. Des courants circulent dans l'amenée de courant 6 et dans le conducteur 8. La jonction 2 est donc soumise à deux champs magnétiques orthogonaux. L'un est appliqué selon l'axe de difficile aimantation de la couche libre, afin de réduire son champ de retournement, l'autre étant appliqué selon son axe facile afin de provoquer le retournement de l'aimantation et l'écriture du point mémoire. Dans le principe, seul le point mémoire placé à l'intersection des deux lignes 6 et 8 est susceptible de se retourner, car chaque champ magnétique pris individuellement n'est pas suffisamment grand pour provoquer un basculement de l'aimantation.

Dans le mode "lecture" (Fig. 1B), le transistor est placé en régime saturé (c'est-à-dire que le courant le traversant est maximum) par l'envoi d'une impulsion de courant positive dans la base. Le courant envoyé dans la ligne 6 traverse uniquement le point mémoire dont le transistor est ouvert. Ce courant permet de mesurer la résistance de la jonction. Par comparaison avec un point mémoire de référence, l'état du point mémoire ("0" ou "1") peut ainsi être déterminé.

Un tel mécanisme d'écriture présente des inconvénients en particulier dans un réseau de jonctions :

1) Comme le renversement de l'aimantation de la couche libre d'une jonction se produit sous l'effet de champs extérieurs et comme les champs de retournement sont statistiquement distribués, il n'est pas impossible de retourner accidentellement certaines jonctions voisines simplement par l'effet du champ magnétique produit le long de la ligne d'adressage. Comme, pour des mémoires à haute densité, la taille des points mémoires est nettement submicronique, le nombre d'erreurs d'adressage augmente.

2) La diminution de la taille des points mémoires entraîne une augmentation de la valeur du champ de retournement individuel ; un courant plus important est alors nécessaire pour écrire les points mémoires, ce qui tend à augmenter la consommation électrique.

3) L'écriture nécessitant deux lignes de courant à 90°, la densité d'intégration se trouve limitée par la présence de ces lignes.

4) Le mode d'écriture utilisé ne permet d'écrire qu'un seul point mémoire à la fois, si l'on veut minimiser le risque d'erreur d'adressage.

Récemment sont apparus d'autres types de dispositifs magnétiques où le renversement de l'aimantation se produit non plus par des champs magnétiques extérieurs mais par des électrons traversant l'empilement perpendiculairement au plan des couches. Ces dispositifs sont décrits dans le document US-A-5,695,864. Le mécanisme mis en oeuvre est fondé sur un transfert de moment magnétique entre les électrons d'une part et l'aimantation de la couche libre, d'autre part. Dans un tel système, l'empilement est formé de couches toutes conductrices de l'électricité, afin de limiter la puissance dissipée. Il en résulte plusieurs inconvénients :

a) la résistance du dispositif est si faible qu'il faut injecter un courant très intense pour avoir une tension aux bornes comparable à celle des systèmes anciens,

b) une telle intensité nécessite un transistor de grande taille, ce qui limite la densité d'intégration de la mémoire,

c) l'amplitude de la variation de résistance obtenue est très faible (2-3%) ce qui limite la tension de sortie,

d) dans l'application aux MRAM, le document cité prévoit trois niveaux de conducteurs et deux sources de tension. Un conducteur central a pour but de récupérer le courant polarisé ayant servi au retournement de la couche libre. Le dispositif est donc complexe.

La présente invention a justement pour but de remédier à ces inconvénients.

**Exposé de l'invention**

A cette fin, l'invention propose d'utiliser des moyens pour polariser le spin des électrons dans une direction perpendiculaire au plan commun des aimantations de l'empilement et, principalement, de l'aimantation dans la couche libre. Cette aimantation va alors tourner autour de la direction de polarisation des spins ce qui permettra d'imposer différents états magnétiques au dispositif.

De manière plus précise, l'invention a pour objet un dispositif magnétique comprenant :

- une première couche magnétique dite "piégée" ayant une aimantation de direction fixe,
- une seconde couche magnétique dite "libre" ayant une aimantation de direction variable,
- une couche isolante séparant la couche piégée et la couche libre,
- des moyens pour faire circuler dans les couches et perpendiculairement à celles-ci un courant d'électrons,
- des moyens de polarisation du spin des électrons, caractérisé en ce que les moyens de polarisation du spin d'une majorité des électrons comprennent au moins une couche magnétique dont l'aimantation est perpendiculaire au plan dans lequel se trouve l'aimantation de la couche libre, cette couche magnétique de polarisation étant séparée de la couche libre par une couche conductrice non magnétique.

Selon un premier mode de réalisation, la couche magnétique de polarisation est une couche à aimantation perpendiculaire au plan des couches, et dans lequel les aimantations des couches piégée et libre sont situées dans le plan desdites couches, le spin des électrons agissant sur l'aimantation de la couche libre étant alors polarisé perpendiculairement au plan de la couche libre et l'aimantation de celle-ci tournant dans le plan de ladite couche libre.

Selon un second mode de réalisation, la couche magnétique de polarisation est une couche à aimantation parallèle au plan des couches, et les aimantations des couches piégée et libre sont situées dans un plan perpendiculaire auxdites couches, le spin des électrons agissant sur l'aimantation de la couche libre étant alors polarisé parallèlement au plan de ladite couche et l'aimantation de celle-ci tournant dans un plan perpendiculaire à ladite couche libre.

La présente invention a également pour objet une mémoire comprenant une matrice de points mémoire adressables par des lignes et des colonnes d'adressage, caractérisée en ce que chaque point mémoire est constitué par un dispositif magnétique tel qu'il vient d'être défini et par un moyen de commutation de courant placé en série avec le dispositif magnétique, chaque dispositif magnétique étant relié à une ligne d'adressage et chaque moyen de commutation à une colonne d'adressage.

La présente invention a également pour objet un procédé d'écriture d'information dans un dispositif tel qu'il vient d'être défini, caractérisé en ce que :

- on fait circuler à travers le dispositif et perpendiculairement au plan des couches un courant d'électrons, lesdits moyens de polarisation polarisant les électrons dans une direction perpendiculaire au plan dans lequel se trouve l'aimantation de la couche libre, ladite aimantation tournant alors dans ce plan,
- on fait cesser ledit courant lorsque l'aimantation de la couche libre se trouve soit parallèle, soit antiparallèle à l'aimantation de la couche piégée.

**Brève description des dessins**

- les figures 1A et 1B, déjà décrites, montrent un dispositif connu pour l'écriture et la lecture d'une information binaire dans une jonction magnétique à effet tunnel et à champ magnétique ;
- la figure 2 montre, en coupe, un premier mode de réalisation d'un dispositif selon l'invention ;
- les figures 3A et 3B montrent les orientations des aimantations dans les différentes couches selon qu'on a écrit un "0" ou un "1" pour ce premier mode de réalisation ;
- les figures 4A et 4B montrent les variations de la composante de l'aimantation selon un axe Oy parallèle au plan des couches pour ces deux cas ("0" et "1) ;
- la figure 5 montre, en coupe, un deuxième mode de réalisation d'un dispositif selon l'invention ;
- les figures 6A et 6B montrent les orientations des aimantations dans les différentes couches selon qu'on a écrit un "0" ou un "1" pour ce deuxième mode de réalisation ;
- les figures 7A et 7B montrent les variations de la composante de l'aimantation selon un axe Oz perpendiculaire au plan des couches pour ces deux cas ("0" et "1") ;
- la figure 8 montre schématiquement une mémoire utilisant une matrice de points mémoire selon l'invention.

**Description de modes particuliers de réalisation**

A propos du phénomène de polarisation de spin pour des électrons circulant dans des dispositifs à jonction tunnel, on peut rappeler les principes suivants. Un courant électrique circulant dans un conducteur est constitué d'électrons dont le spin n'a aucune raison a priori d'être orienté dans une direction particulière. Mais, à la traversée d'une couche magnétique présentant une aimantation particulière, les spins vont se trouver orientés par des phénomènes d'échange de moment magnétique de sorte que les électrons sortiront de cette couche avec un spin polarisé. Une telle couche (ou un ensemble de telles couches) constitue ainsi un "polariseur". Ce phénomène peut jouer aussi bien en transmission (à travers une couche) qu'en réflexion (sur certaines couches), selon la direction de circulation du courant. Il peut également jouer en sens inverse en laissant passer de préférence des électrons ayant un spin polarisé dans une certaine direction. La fonction de la couche est alors celle d'un analyseur.

S'agissant maintenant du premier mode de réalisation de l'invention, il consiste d'abord à utiliser une jonction tunnel formée de deux couches magnétiques disposées de part et d'autre d'une couche isolante. L'une des couches a sa direction d'aimantation fixée par couplage d'échange avec une couche antiferromagnétique : c'est la couche piégée. Cette couche remplit le double rôle de polariseur (à l'écriture) et d'analyseur (à l'écriture et à la lecture). La seconde couche a son aimantation libre. Elle ne peut tourner que dans le plan de la couche à cause du champ démagnétisant présent dans la couche. Le dispositif comprend encore un polariseur formé par un système à aimantation perpendiculaire.

Pour l'écriture, on fait circuler un courant à travers la jonction avec une intensité suffisamment faible pour ne pas provoquer le retournement de l'aimantation de la couche libre (ce retournement pourrait se produire mais pour des densités très élevées qui détruiraient la jonction). Les électrons, réfléchis ou transmis par le polariseur, seront polarisés avec une direction de spin perpendiculaire aux plans de couches. Ces électrons à spin ainsi polarisé vont provoquer une rotation continue de l'aimantation de la couche libre dans le plan de la couche. Si la couche libre était magnétiquement isotrope, une composante de l'aimantation selon un axe parallèle à la couche aurait une variation temporelle sinusoïdale. Mais la couche libre n'est pas isotrope et présente une anisotropie magnétique uniaxiale qui crée un axe de facile aimantation (avec deux directions possibles). Pour une telle couche anisotrope, les variations d'une composante de l'aimantation seront déformées et présenteront deux plateaux d'égale durée correspondant aux deux directions de facile aimantation. La polarisation du spin des électrons imposée par la couche piégée favorisera alors l'une des deux directions de l'aimantation de la couche libre donc augmentera la durée d'un des deux plateaux en fonction du sens du courant. Cette augmentation de la durée d'un des plateaux permet de limiter le risque d'erreur lors de l'écriture par des impulsions de courant. A l'aide d'une impulsion de courant de durée déterminée, il sera ainsi possible de sélectionner l'un de ces plateaux pour donner à la couche libre une aimantation soit parallèle soit antiparallèle à la direction de l'aimantation de la couche piégée directement adjacente à la couche isolante.

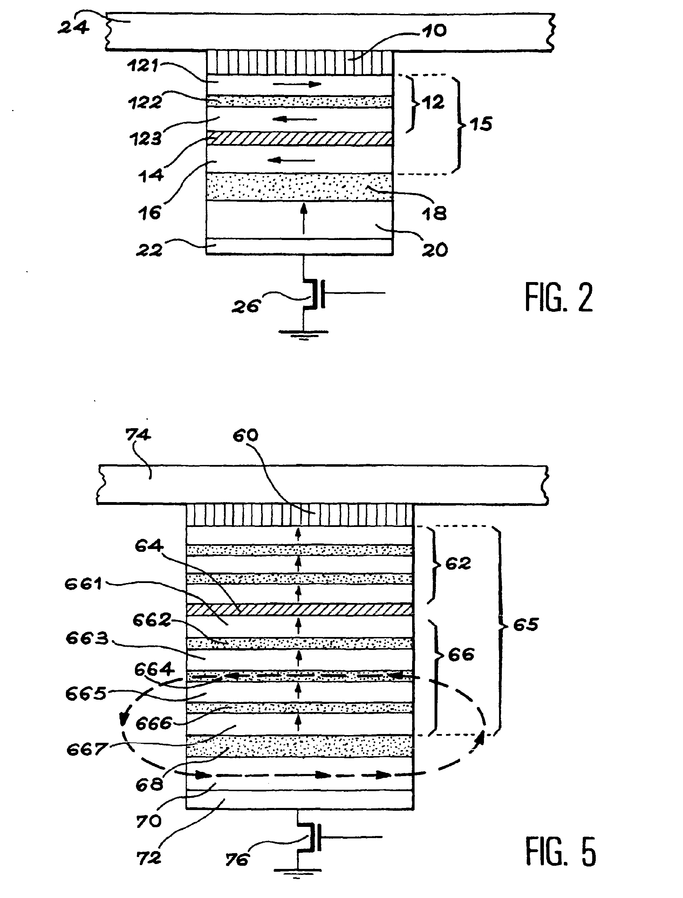

Ce premier mode de réalisation est illustré sur la figure 2. Le dispositif représenté comprend une couche antiferromagnétique 10, un empilement tricouche 12 constitué par deux couches magnétiques 121, 123 à aimantations planaires antiparallèles, séparées par une couche conductrice non magnétique. Cet empilement constitue la couche piégée. Le dispositif comprend encore une couche isolante 14, et une couche magnétique libre 16. L'ensemble 12, 14, 16 constitue une jonction tunnel magnétique 15.

Le dispositif se complète par une couche séparatrice métallique 18 et une couche magnétique de polarisation 20 ayant une aimantation perpendiculaire au plan de la couche. Cette couche 20 peut être composée d'un empilement de couches, par exemple en Fe/Pt ou en Fe/Pd ou en Co/Pt, ou en Co/Pd, ou en Co/Au, etc... ou en leurs alliages ordonnés. La couche de polarisation repose sur un substrat conducteur 22. L'ensemble de cet empilement est inséré entre une amenée de courant 24 et un moyen de commutation de courant, qui est ici un transistor 26.

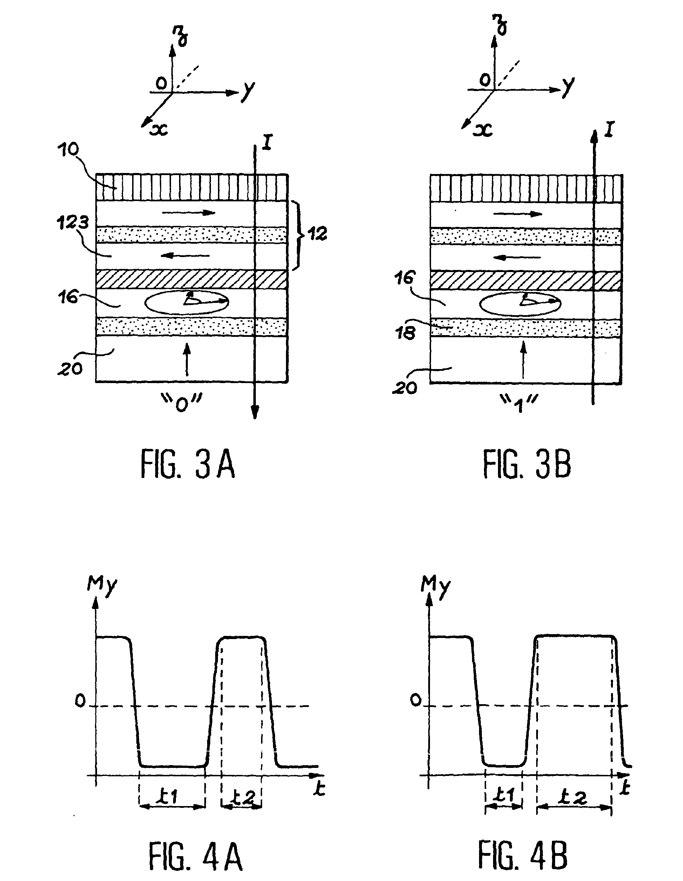

Pour les électrons transmis à travers la couche 20 ou réfléchis par celle-ci, la direction du spin se trouvera être orientée parallèlement à l'aimantation de cette couche, c'est-à-dire perpendiculairement au plan des diverses couches de la jonction 15 et en particulier au plan de la couche libre 16. L'aimantation de cette couche soumise à ce courant d'électrons polarisés va tourner dans le plan de la couche, sans pouvoir s'aligner avec la direction de spin du fait du champ démagnétisant qui s'exerce dans la couche. Les figures 3A et 3B montrent symboliquement cette rotation. Un trièdre trirectangle Oxyz permet de repérer les différentes directions, l'axe Oz étant perpendiculaire au plan des couches.

Si le courant est positif (figure 3A) mais de densité inférieure à la densité critique, la polarisation induite par la couche 123 ne permettra pas le retournement de l'aimantation de la couche 16 mais favorisera une direction d'aimantation selon (-y). Dans la rotation de l'aimantation décrite précédemment, on observera alors une différence de largeur des créneaux avec une augmentation de la durée du plateau selon (-y) et une diminution selon (+y). C'est ce que représente la figure 4A avec des durées $t_1$ et $t_2$ pour les plateaux avec $t_1 > t_2$. En faisant circuler dans la jonction un courant pulsé de durée judicieusement déterminée, on favorisera l'écriture d'un élément binaire qu'on peut noter "0". Si le sens du courant est inversé (Fig.3B), la direction d'aimantation favorisée s'inverse et le déséquilibre dans la durée des plateaux s'inverse également (Fig. 4B) avec $t_1 < t_2$. On privilégiera alors l'écriture d'un "1". On a donc soit My>0 (antiparallélisme dans le cas illustré), soit My<0 (parallélisme).

Les avantages de ce dispositif sont une faible densité de courant et une grande rapidité d'écriture car la rotation dans le plan est bien plus rapide que le basculement de l'aimantation, comme on en trouve dans l'art antérieur, qui demande un grand nombre d'oscillations de précession.

Pour la lecture, l'impulsion de courant est de durée et/ou d'intensité inférieure à celle de l'impulsion d'écriture, afin de lire l'état magnétique du dispositif sans risque de réécriture.

Selon un second mode de réalisation, le dispositif comprend une jonction tunnel formée d'une barrière d'oxyde en sandwich entre deux systèmes à aimantation perpendiculaire. Un des systèmes à aimantation perpendiculaire est en interaction d'échange avec une couche antiferromagnétique afin de fixer la direction de son aimantation. Il joue le double rôle de polariseur (à l'écriture) et d'analyseur (à l'écriture et à la lecture). Le second système à aimantation perpendiculaire est libre d'orienter son aimantation dans la direction des spins polarisés. Le dispositif comprend en outre un polariseur à aimantation planaire formé d'une couche magnétique épaisse ou d'un empilement tri-couche dont les épaisseurs des deux couches magnétiques sont différentes. L'ajout d'un polariseur à aimantation planaire induit un champ de couplage magnétostatique dans le plan des couches qui tend à réduire l'anisotropie perpendiculaire effective et permet donc de réduire la densité de courant critique. Le polariseur planaire provoque une rotation continue de l'aimantation de la couche libre dans un plan perpendiculaire à l'aimantation de ce polariseur. Le polariseur perpendiculaire permet de favoriser un état magnétique stable et donc de sélectionner l'information binaire à écrire ("0" ou "1"). En mode écriture, un courant pulsé est envoyé à travers la jonction dont la durée est contrôlée pour provoquer le basculement de l'aimantation de la couche libre. Grâce à ces deux polariseurs, le courant d'écriture est abaissé et le temps d'écriture est fortement diminué. En mode lecture le courant pulsé traversant la jonction est de durée inférieure à l'écriture.

Ce second mode de réalisation est illustré sur la figure 5. Le dispositif représenté comprend une couche antiferromagnétique 60, un empilement 62 de couches alternativement magnétique et non magnétique, une couche isolante 64 et un empilement 66 de couches alternativement magnétiques et non magnétiques. L'empilement 62 constitue la couche piégée avec des aimantations perpendiculaires au plan des couches. L'ensemble des empilements 62 et 66 séparés par la couche isolante 64 constitue une jonction tunnel magnétique 65. Le dispositif comprend encore une couche conductrice non magnétique 68 et une couche magnétique 70 de polarisation reposant sur un substrat conducteur 72. L'ensemble de cet empilement est inséré entre une ligne d'amenée de courant 74 et un moyen de commutation de courant, en l'espèce un transistor 76.

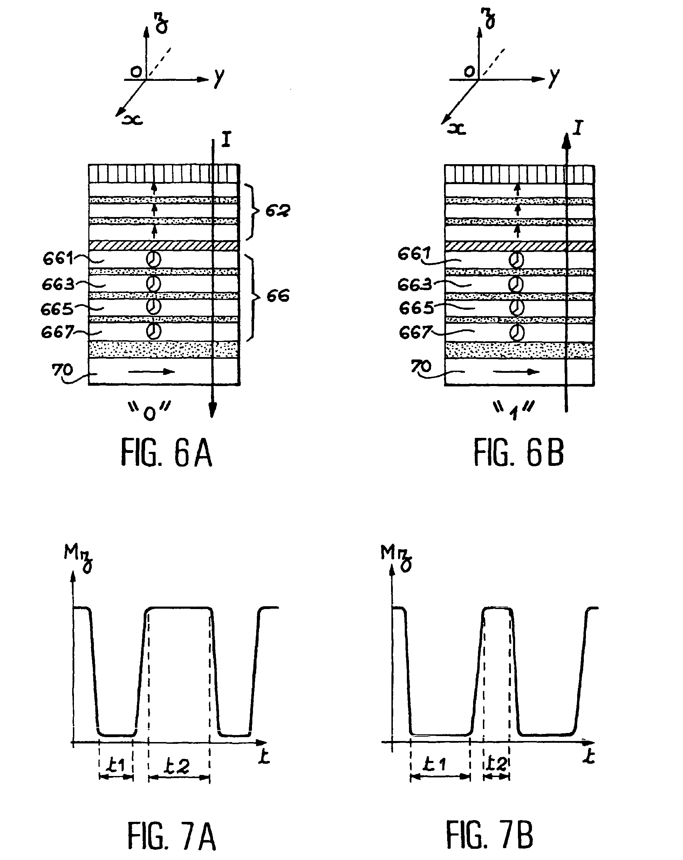

Les figures 6A et 6B montrent le mécanisme d'écriture d'un "0" et d'un "1" et la rotation de l'aimantation dans la couche libre 66, et plus précisément dans les sous-couches 661, 663, 665 et 667 composant cette couche. Sur la figure 6A, le courant circule de haut en bas et sur la figure 6B de bas en haut.

Les figures 7A et 7B montrent les variations de la composante Mz de l'aimantation selon l'axe Oz. Pour la figure 7A, le parallélisme des aimantations correspond au plateau le plus long et pour la figure 7B, c'est au contraire l'antiparallélisme.

Le rôle de la couche à aimantation planaire 70 est double : i) polariser les électrons avec un axe de polarisation dans le plan des couches, ii) créer un couplage magnétostatique dans le plan de la couche 66 afin de réduire l'anisotropie effective de cette couche et faciliter la rotation de l'aimantation de la couche 66 autour de l'axe de polarisation des électrons accumulés ou transmis par la couche 70.

Le matériau de la couche 70 est de préférence une couche épaisse de métal de transition (Fe, Ni ou Co) ou un alliage de métaux de transition. La direction de son aimantation ne peut varier en présence de courant car la densité requise pour cette variation est très supérieure' à celle qui est utilisée pour l'écriture ou la lecture. L'épaisseur doit être ajustée pour contrôler l'intensité du couplage magnétostatique avec la couche 66 et pour optimiser la polarisation des électrons. Par ailleurs, le fait d'avoir une forte épaisseur permet de fixer la direction de l'aimantation (par son champ coercitif) sans utiliser de couche d'échange.

Le procédé d'écriture reprend les principes déjà exposés pour la première variante et joue sur l'anisotropie magnétique uniaxiale de la couche libre. Pour l'écriture d'un "O", un courant positif traverse le système (cf. Fig. 6A). Les électrons qui s'accumulent sur la couche 70 vont provoquer une rotation des aimantations de la couche 66. La composante Mz aurait une caractéristique purement sinusoïdale en l'absence d'anisotropie. En raison de l'anisotropie magnétique uniaxiale de la couche libre, les variations d'une composante de l'aimantation présenteront deux plateaux égaux correspondant aux deux directions de facile aimantation. La polarisation du spin des électrons imposée par la couche piégée 62 favorisera la direction d'aimantation selon +z : le plateau correspondant à Mz>0 est allongé, ce qui favorise l'état magnétique "0". Par un choix approprié de la durée de l'impulsion d'écriture, on sélectionne ainsi l'état "0". La vérification de l'état est effectuée par lecture de la tension aux bornes de la jonction et comparaison avec une cellule référence. Pour l'écriture d'un "1", le processus est identique mais un courant négatif circule dans le système (Fig. 6B). L'état Mz<0 est alors favorisé aux dépends de Mz>0. La lecture de l'état magnétique d'un dispositif se fait à l'aide d'un courant pulsé de faible densité et de durée inférieure à la durée des plateaux.

Les deux modes de réalisation qui viennent d'être décrits peuvent être comparés dans le tableau ci-dessous, où :

- t est l'épaisseur de la couche magnétique à retourner,

- Ms est l'aimantation à saturation de la couche à retourner avec CoFe Ms=1500 emu/cc),
- Hk est l'anisotropie de la couche magnétique à retourner,
- Jc (écriture) est la densité de courant pour écrire un point mémoire,
- $RA_{max}$ est le produit de la résistance par la surface de la jonction tunnel, défini de telle façon que la tension à l'écriture n'excède pas 0,6 V,
- Jc (lecture) est la densité de courant pour une tension de lecture de 0,3 V avec $RA_{max}$,
- $a_{min}$ est la taille minimale d'un côté du point mémoire (pour un point mémoire carré) avant d'atteindre la limite superparamagnétique.

La valeur de $a_{min}$ est calculée d'après la formule :

$$a_{min} = \sqrt{\frac{84 k_B T}{M_s H_k t}}$$

dans laquelle la valeur 84 est calculée en considérant une durée de fonctionnement de la mémoire de 100 ans à une température de 100°C.

| Mode de réalisation | 1 | 2 |
|---|---|---|
| t(nm) | 5 | 2 |
| Ms (emu/cc) | 1500 | 1500 |
| Hk effectif (G) | 40 | 100 |
| Jc (écriture) (A/cm$^2$) | 1,6E + 05 | 1,6E + 05 |
| $RA_{max}$ (Ohm.$\mu$m$^2$) | 375 | 375 |
| Jc (lecture) (A/cm$^2$) | 8E + 04 | 8E + 04 |
| $a_{min}$ (micron) | 0,12 | 0,12 |

On voit qu'avec l'invention on peut atteindre de faibles densités de courant d'écriture, compatibles avec des jonctions de produit RA raisonnables (>100 $\Omega.\mu$m$^2$). De tels produits RA peuvent être obtenus, soit par oxydation plasma, soit et de préférence par oxydation naturelle in situ.

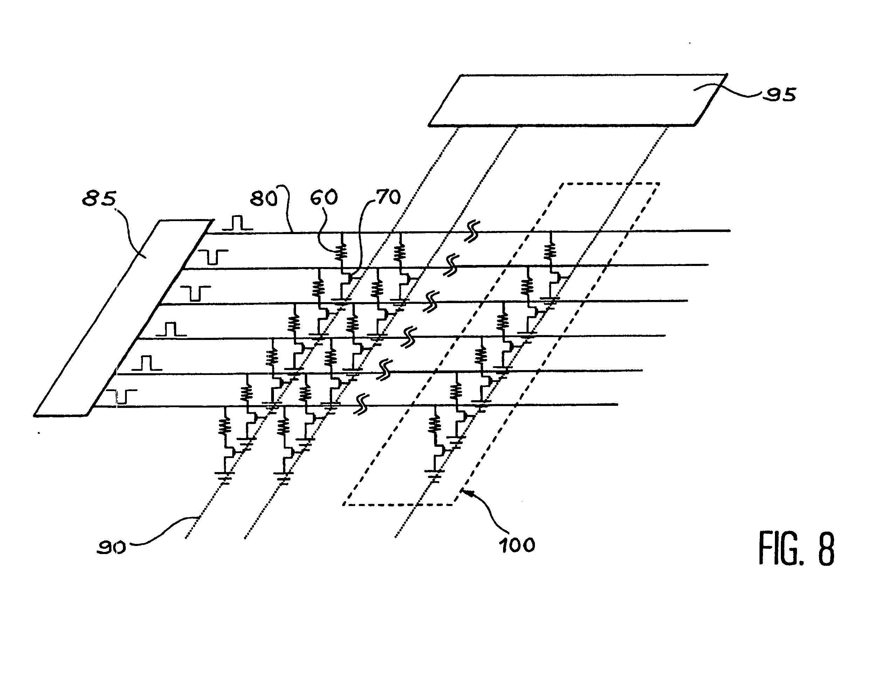

La figure 8, enfin, montre une mémoire formée d'une matrice de points mémoires adressable par lignes et colonnes. Chaque point mémoire comprend un dispositif conforme à l'invention, avec un empilement de couches symbolisé par une résistance 60 et un moyen de commutation constitué par un transistor 70. Chaque empilement est relié à une ligne d'adressage 80 et la base (ou la porte) du transistor à une colonne d'adressage 90. Les lignes 80 sont dites "lignes de bits" et les colonnes 90 "lignes de mot" (ou de digit). Les lignes 80 sont reliées aux sorties d'un circuit d'adressage ligne 85 et les colonnes 90 aux sorties d'un circuit d'adressage colonne 95.

Lorsqu'une séquence de bits doit être écrite (par exemple 100110), on commande l'adressage d'une colonne par une impulsion apte à ouvrir les transistors de la colonne et on envoie sur chaque ligne une impulsion de courant de polarité appropriée (dans l'exemple pris +--++-). Tous les bits se trouvent ainsi écrits dans la colonne de la mémoire, simultanément.

Cet adressage multiple est possible grâce à l'invention puisque, comme expliqué dans l'introduction, un point mémoire peut être écrit sans risque de perturbation des points voisins ni écriture intempestive au voisinage.

L'écriture de la mémoire entière peut aussi s'effectuer colonne par colonne.

Quelque part dans la mémoire, par exemple au centre, se trouve une colonne de référence 100 qui permet la lecture multiple. Lorsqu'un courant de lecture circule dans les points mémoires d'une colonne 90, on compare la tension de lecture de chaque point avec la tension lue sur le point mémoire de la colonne de référence appartenant à la même ligne.

Ce mécanisme d'écriture et de lecture par colonne réduit considérablement le temps de cycle de la mémoire.

**Revendications**

1. Dispositif magnétique comprenant :

   • une première couche magnétique (12, 62) dite "piégée" ayant une aimantation de direction fixe,
   • une seconde couche magnétique (16, 66) dite "libre" ayant une aimantation de direction variable,
   • une couche isolante ou semi-conductrice (14, 64) séparant la couche piégée (12, 62) et la couche libre (16, 66),
   • des moyens (24, 74, 26, 76) pour faire circuler dans les couches et perpendiculairement à celles-ci un courant d'électrons,
   • des moyens de polarisation du spin des électrons,

   **caractérisé en ce que** les moyens de polarisation du spin des électrons comprennent au moins une couche magnétique (20, 70) dont l'aimantation est perpendiculaire au plan dans lequel se trouve l'aimantation de la couche libre (16, 66), cette couche magnétique de polarisation (20, 70) étant séparée de la couche libre (16, 66) par une couche conductrice non magnétique (18, 64).

2. Dispositif selon la revendication 1, dans lequel la couche magnétique de polarisation (20) est une couche à aimantation perpendiculaire au plan des couches (12, 14, 16, 20), et dans lequel les aimantations des couches piégée (12) et libre (16) sont situées dans le plan desdites couches (12, 16), le spin des électrons agissant sur l'aimantation de la couche libre (16) étant alors polarisé perpendiculairement au plan de la couche libre (16) et l'aimantation de celle-ci tournant dans le plan de ladite couche libre (16).

3. Dispositif selon la revendication 2, dans lequel la couche piégée (12) présente une aimantation située dans le plan de la couche.

4. Dispositif selon la revendication 2, dans lequel la couche magnétique de polarisation est formée d'un empilement de couches (20).

5. Dispositif selon la revendication 4, dans lequel l'empilement de couches est constitué d'alternance de couches en matériaux pris dans le groupe comprenant Fe, Pt, Pd, Co, Au et leurs alliages.

6. Dispositif selon la revendication 1, dans lequel la couche magnétique de polarisation (70) est une couche à aimantation parallèle au plan des couches, et dans lequel les aimantations des couches piégée (62) et libre (66) sont situées dans un plan perpendiculaire auxdites couches, le spin des électrons agissant sur l'aimantation de la couche libre (66) étant alors polarisé parallèlement au plan de ladite couche et l'aimantation de celle-ci tournant dans un plan perpendiculaire à ladite couche libre (66).

7. Dispositif selon la revendication 6, dans lequel la couche libre (66) présente une anisotropie dans un plan perpendiculaire au plan de ladite couche libre.

8. Dispositif selon la revendication 6, dans lequel la couche piégée (62) présente une aimantation perpendiculaire au plan de ladite couche piégée.

9. Dispositif selon la revendication 6, dans lequel la couche magnétique de polarisation (70) est en matériau pris dans le groupe comprenant Fe, Ni, Co et leurs alliages.

10. Dispositif selon la revendication 6, dans lequel la couche libre (66) comprend plusieurs couches magnétiques (661, 663, 665, 667) séparées par des couches conductrices non magnétiques (662, 664, 666).

11. Mémoire comprenant une matrice de points mémoire adressables par des lignes et des colonnes d'adressage, **caractérisée en ce que** chaque point mémoire est constitué par un dispositif magnétique (60) selon l'une quelconque des revendications 1 à 10, et par un moyen de commutation de courant (70) placé en série avec le dispositif magnétique (60), chaque dispositif magnétique (60) étant relié à une ligne d'adressage (80) et chaque moyen de commutation à une colonne d'adressage (90).

12. Mémoire selon la revendication 11, comprenant en outre une colonne de référence (100) et des moyens pour comparer la tension lue aux bornes du dispositif magnétique (60) situé au croisement d'une ligne (80) et d'une colonne (90) déterminées avec la tension lue aux bornes du dispositif magnétique situé sur la même ligne (80) mais sur la colonne de référence (100).

13. Procédé d'écriture d'information dans un dispositif conforme à l'une quelconque des revendications 1 à 10, **caractérisé en ce que :**

- on fait circuler à travers le dispositif et perpendiculairement au plan des couches un courant d'électrons, lesdits moyens de polarisation polarisant les électrons dans une direction perpendiculaire au plan dans lequel se trouve l'aimantation de la couche libre, ladite aimantation tournant alors dans ce plan,
- on fait cesser ledit courant lorsque l'aimantation de la couche libre se trouve soit parallèle, soit antiparallèle à l'aimantation de la couche piégée.

**Claims**

1. Magnetic device consisting of :

■ a first magnetic layer (12, 62) called the "anchored" layer which has a fixed magnetisation direction,
■ a second magnetic layer (16, 66) called the "free" layer which has a variable magnetisation direction,
■ an insulating or semi-conducting layer (14, 64) which separates the anchored layer (12, 62) from the free layer (16, 66),
■ means (24, 74, 26, 76) for passing a current of electrons through and perpendicular to the layers,
■ means for polarising the spin of the electrons,

**characterised in that** the means for polarising the spin of the electrons include at least one magnetic layer (20, 70) whose magnetisation is perpendicular to the plane of the magnetisation of free layer (16, 66), this magnetic polarisation layer (20, 70) being separated from the free layer (16, 66) by a non-magnetic conducting layer (18, 64).

2. Device in accordance with claim 1, in which the magnetic polarisation layer (20) is a layer whose magnetisation is perpendicular to the plane of the layers (12, 14, 16, 20), and in which the magnetisation of the anchored (12) and free (16) layers are located within the plane of the said layers, the spin of the electrons acting on the magnetisation of the free layer (16) then being polarised perpendicularly to the plane of the free layer (16) and the magnetisation of the latter rotating within the plane of the said free layer (16).

3. Device in accordance with claim 2, in which the magnetisation of the anchored layer (12) is located within the plane of the layer.

4. Device in accordance with claim 2, in which the magnetic polarisation layer consists of a stack of layers (20).

5. Device in accordance with claim 4, in which the stack of layers consists of alternate layers of materials taken from the group consisting of Fe, Pt, Pd, Co, Au and their alloys.

6. Device in accordance with claim 1, in which the magnetic polarisation layer (70) is a layer whose magnetisation is parallel to the plane of the layers, and in which the magnetisation of the anchored (62) and free (66) layers is located in a plane perpendicular to the said layers, the spin of the electrodes acting on the free layer (66) then being polarised parallel to the said layer and its magnetisation rotating in a plane perpendicular to the said free layer (66).

7. Device in accordance with claim 6, in which the free layer (66) exhibits anisotropy in a plane perpendicular to the said free layer.

8. Device in accordance with claim 6, in which the anchored layer (62) is magnetised perpendicularly to the said anchored layer.

9. Device in accordance with claim 6, in which the magnetic polarisation layer (70) is made of a material taken from the group consisting of Fe, Ni, Co and their alloys.

10. Device in accordance with claim 6, in which the free layer (66) consists of several magnetic layers (661, 663, 665, 667) separated by conducting non-magnetic layers (662, 664, 666).

11. Memory consisting of a matrix of memory cells addressable in rows and columns, **characterised in that** each memory cell consists of a magnetic device (60) in accordance with any of claims 1 to 10, and by a current switching device (70) connected in series with the magnetic device (60), each magnetic device (60) being connected to an addressing row (80) and each switching device (70) to an addressing column (90).

12. Memory in accordance with claim 11, including additionally a reference column (100) and means for comparing the voltage read at the terminals of the magnetic device (60) located at the intersection between a row (80) and a column (90), and the voltage read at the terminals of the magnetic device located on the same row (80) but in the reference column (100).

13. Data writing process in a device in accordance with any of claims 1 to 10, **characterised in that** :

- a current of electrons is passed through the device and perpendicularly to the plane of the layers, the said polarising means polarising the electrons in a direction perpendicular to the plane of the magnetisation of the free layer, the said magnetisation then rotating within that plane,
- the said current is cut off when the magnetisation of the free layer is either parallel or antiparallel to the magnetisation of the anchored layer.

**Patentansprüche**

1. Magnetische Vorrichtung, umfassend:

• eine erste, sogenannte "gefangene" magnetische Schicht (12, 62), die eine Magnetisierung mit festgelegter Richtung hat,
• eine zweite, sogenannte "freie" magnetische Schicht (16, 66), die eine Magnetisierung mit variabler Richtung hat,
• eine die gefangene Schicht (12, 62) und die freie Schicht (16, 66) trennende Isolier- oder Halbleiterschicht (14, 64),
• Einrichtungen (24, 74, 26, 76) um in den Schichten und senkrecht zu diesen einen Elektronenstrom fließen zu lassen,
• Elektronenspin-Polarisationseinrichtungen,

**dadurch gekennzeichnet, dass** die Elektronenspin-Polarisationseinrichtungen wenigstens eine magnetische Schicht (20, 70) umfassen, deren Magnetisierung senkrecht ist zu der Ebene der Magnetisierung der freien Schicht (16, 66), wobei diese magnetische Polarisationsschicht (20, 70) von der freien Schicht (16, 66) durch eine nichtmagnetische Leiterschicht (18, 64) getrennt ist.

2. Vorrichtung nach Anspruch 1, bei der die magnetische Polarisationsschicht (20) eine Schicht mit einer zur Ebene der Schichten (12, 14, 16, 20) senkrechten Magnetisierung ist, und bei der die Magnetisierungen der gefangenen (12) und freien (16) Schicht sich in der Ebene der genannten Schichten (12, 16) befinden, wobei der auf die Magnetisierung der freien Schicht (16) wirkende Spin der Elektronen dann senkrecht zu der Ebene der freien Schicht (16) polarisiert wird und die Magnetisierung von dieser sich in der Ebene der genannten freien Schicht (16) dreht.

3. Vorrichtung nach Anspruch 2, bei der die gefangene Schicht (12) eine in der Ebene der Schicht befindliche Magnetisierung aufweist.

4. Vorrichtung nach Anspruch 2, bei der die magnetische Polarisationsschicht durch einen Schichtenstapel (20) gebildet wird.

5. Vorrichtung nach Anspruch 4, bei der der Schichten stapel abwechselnd durch Schichten aus Materialien der Gruppe gebildet wird, die Fe, Pt, Pd, Co, Au und ihre Legierungen umfasst.

6. Vorrichtung nach Anspruch 1, bei der die magnetische Polarisationsschicht (70) eine Schicht mit einer zu der Ebene der Schichten parallelen Magnetisierung ist, und bei der sich die Magnetisierungen der gefangenen (62) und freien (66) Schicht in einer zu den genannten Schichten senkrechten Ebene befinden, wobei der auf die Magnetisierung der freien Schicht (66) wirkende Spin der Elektronen dann parallel zu der Ebene der genannten Schicht polarisiert wird und die Magnetisierung von dieser sich in einer zu der genannten freien Schicht (66) senkrechten Ebene dreht.

7. Vorrichtung nach Anspruch 6, bei der die freie Schicht (66) in einer zu der Ebene der genannten freien Schicht senkrechten Ebene eine Anisotropie aufweist.

8. Vorrichtung nach Anspruch 6, bei der die gefangene Schicht (62) eine zu der Ebene der genannten gefangenen Schicht senkrechte Magnetisierung aufweist.

9. Vorrichtung nach Anspruch 6, bei der die magnetische Polarisationsschicht (70) aus einem Material aus der Gruppe ist, die Fe, Ni, Co und ihre Legierungen umfasst.

10. Vorrichtung nach Anspruch 6, bei der die freie Schicht (66) mehrere magnetische Schichten (661, 663, 665, 667), getrennt durch nichtmagnetische Leiterschichten (662, 664, 666), umfasst.

11. Speicher mit einer Matrix von Speicherpunkten, adressierbar durch Adressierungszeilen und -spalten, **dadurch gekennzeichnet, dass** jeder Speicherpunkt gebildet wird durch eine magnetische Vorrichtung nach einem der Ansprüche 1 bis 10 und durch eine Strom schalteinrichtung (70), in Serie mit der magnetischen Vorrichtung (60) angeordnet, wobei jede magnetische Vorrichtung (60) mit einer Adressierungsleitung (80) und jede Schalteinrichtung mit einer Adressierungsspalte (90) verbunden ist.

12. Speicher nach Anspruch 11 mit außerdem einer Referenzspalte (100) und Einrichtungen zum Vergleichen der an den Anschlüssen der an der Kreuzung einer bestimmten Zeile (80) und einer bestimmten Spalte (90) befindlichen magnetischen Vorrichtung (60) abgegriffenen Spannung mit der an den Anschlüssen derjenigen magnetischen Vorrichtung abgegriffenen Spannung, die sich in derselben Zeile (80), aber in der Referenzspalte (100) befindet.

13. Verfahren um Informationen in eine Vorrichtung nach einem der Ansprüche 1 bis 10 zu schreiben, **dadurch gekennzeichnet, dass**:

   - man durch die Vorrichtung und senkrecht zu der Ebene der Schichten einen Elektronenstrom fließen lässt, wobei die genannten Poiarisationseinrichtungen die Elektronen in einer Richtung polarisieren, die senkrecht zu der Ebene ist, in der sich die Magnetisierung der freien Schicht befindet, wobei die genannte Magnetisierung sich dann in dieser Ebene dreht,
   - man den genannten Strom beendigt, wenn die Magnetisierung der freien Schicht entweder parallel oder antiparallel zu der Magnetisierung der gefangenen Schicht ist.

FIG. 1A

FIG. 1B

FIG. 2

FIG. 5

FIG. 3A

FIG. 3B

FIG. 4A

FIG. 4B

FIG. 6 A

FIG. 6 B

FIG. 7A

FIG. 7B

FIG. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5695864 A